# FASCICULE DE BREVET EUROPEEN

(11) **EP 2 306 599 B1**
(45) Date de publication et mention de la délivrance du brevet: **28.02.2018**
(21) Numéro de dépôt: 10181103.2
(22) Date de dépôt: 28.09.2010
(51) Int. Cl.: H01R 12/62, F21S 8/10, H05K 1/14, H01R 12/57, F21Y 115/10

(54) **Support pour source lumineuse de module d'éclairage**
Halterung für lichtquelle eines beleuchtungsmoduls
Support for a light source of a lighting module

(30) Priorité: 30.09.2009 FR 0956783
(43) Date de publication de la demande: 06.04.2011
(73) Titulaire: VALEO VISION, 93012 Bobigny (FR)
(72) Inventeur: Nicolai, Jean-Marc, 92400 Courbevoie (FR); Thullier, Christophe, 78180 Montigny Le Bretonneux (FR)

(56) Documents cités:
- EP-A1- 1 675 223
- EP-A2- 1 630 474
- WO-A1-2008/081969
- DE-A1-102007 049 310
- US-A1- 2007 171 662
- US-B1- 6 294 255

## Description

L'invention a trait à un support de source lumineuse pour module d'éclairage ou de signalisation. Plus particulièrement l'invention a trait à un support de source lumineuse montée sur premier circuit imprimé, et plus particulièrement pour une source lumineuse du type à électroluminescence d'un dispositif d'éclairage requérant une certaine puissance d'éclairage.

Les sources lumineuses à diode électroluminescente, encore appelées DEL ou LED, sont actuellement préférées aux sources plus classiques comme les lampes à décharge et les lampes halogènes, et ce pour diverses raisons. Les diodes électroluminescentes présentent un certain nombre d'avantages. Tout d'abord, depuis longtemps, on sait que ce type de diodes ne rayonne pas de façon omnidirectionnelle, mais rayonne dans un demi espace opposé à un substrat qui supporte les éléments photoémissifs de la diode électroluminescente ; ainsi, en utilisant un rayonnement plus directif, la quantité d'énergie perdue est moins importante qu'avec des lampes à décharges ou halogènes. Ensuite, on a récemment perfectionné ces diodes en terme de puissance rayonnée. Enfin, les DEL consomment moins d'énergie, même à puissance rayonnée égale, que les lampes à décharge ou les lampes halogènes ; elles sont peu encombrantes, et leur forme particulière offre des possibilités nouvelles pour la réalisation et la disposition des surfaces complexes qui leur sont associées, notamment en les disposant sur des supports électroniques de type support électronique souple. Un certain nombre de contraintes, liées à la dissipation de chaleur demeurent cependant importantes pour les DEL de puissance. Par l'expression "DEL de puissance", on désigne une diode électroluminescente dont le flux lumineux est de l'ordre d'au moins 30 lumens. Pour refroidir des composants électroniques, et notamment des diodes de puissance, il est connu de monter le composant à refroidir sur un radiateur. La convection naturelle qui s'opère avec le radiateur assure le refroidissement. On utilise par conséquent un radiateur de dimension suffisante pour refroidir le composant de manière satisfaisante.

Une source lumineuse du type à électroluminescence est souvent formée par application de couches semi-conductrices sur un substrat ou directement sur un circuit imprimé, qui est alors à la fois substrat et circuit imprimé sur lequel est fixé la DEL. Ce type de réalisation de source lumineuse à diode électroluminescence est particulièrement utilisé pour les sources lumineuses de puissance, telles que celles que l'on retrouve dans les dispositifs d'éclairage, notamment dans les projecteurs automobiles.

La source lumineuse d'un dispositif d'éclairage ou de signalisation doit pouvoir être positionnée avec précision, être connectée électriquement à une alimentation électrique et être refroidie. Pour ce faire un support adéquat est nécessaire.

Le document EP 1 630 474 A2 divulgue un support de DEL sur un substrat pour un dispositif d'éclairage de véhicule. Le substrat comprend les électrodes permettant de mettre sous tension l'élément photoémissif de la DEL. Le support assure un positionnement approximatif de la source lumineuse par rapport au support lui-même ainsi qu'une liaison électrique entre les électrodes du substrat et un connecteur intégré au support. La liaison électrique est assurée par des contacts élastiques venant en pression avec les contacts correspondants sur la face supérieure du substrat. La dissipation de chaleur est assurée par une ouverture du support laissant libre la face inférieure du substrat de sorte à pouvoir la poser sur un radiateur de dissipation de chaleur.

Le support de cet enseignement présente cependant quelques inconvénients. En effet, il ne permet pas un positionnement exact mais bien flottant de la source lumineuse. L'opération de montage du support de la source lumineuse au module ou dispositif d'éclairage nécessite donc une manipulation précise afin d'assurer les qualités optiques et photométriques du module ou dispositif d'éclairage. De plus, le connecteur intégré au support peut rendre l'opération de connexion de la source lumineuse au module électrique d'alimentation assez difficile. En effet, les dispositifs d'éclairage présentent souvent une accessibilité réduite, en particulier au niveau de l'endroit de positionnement des sources lumineuses.

Le document FR 2 922 167 A1 divulgue un exemple de réalisation d'un principe de montage d'une DEL sur un module d'éclairage. La DEL comprend quatre éléments photoémissifs disposés sur un circuit imprimé qui est lui-même fixé à un support. Le support est disposé sur un dissipateur de chaleur au moyen d'un dispositif de fixation comprenant deux languettes venant prendre appui, chacune, sur le fond d'un évidement pratiqué sur deux bords opposés du support. Ce dispositif est cependant plus compliqué et en cas d'accessibilité réduite, l'opération de connexion reste difficile.
Le but de l'invention est de proposer un support de source lumineuse permettant une intégration plus simple dans un module optique pour véhicule automobile.
Un objet de l'invention est un support de source lumineuse selon la revendication 1. Le support selon l'invention assure un positionnement entre un circuit imprimé souple et le support et permet ainsi d'établir une liaison électrique rigide fiable avant montage (typiquement en usine) entre les conducteurs du circuit imprimé souple et les conducteurs du premier circuit imprimé. Le support peut donc être monté avec une section du circuit imprimé souple tout en garantissant la liaison mécanique et électrique entre les deux. Il en résulte une grande liberté d'orientation de montage au vu de la souplesse du circuit imprimé souple. Dans le cas de l'enseignement du document EP 1 630 474 A2, le support, de par l'intégration du connecteur, ne permet pas la liberté d'orientation que permet le support de l'invention. La présente invention permet également de fixer directement le support du premier circuit imprimé à un dissipateur thermique. Par circuit imprimé souple, on entend dans la présente demande un circuit imprimé dont le matériau isolant et intégrant les pistes conductrices est réalisé en un polymère souple. Ce type de circuit imprimé a typiquement une forme de ruban et est également connu par l'homme du métier sous le nom de « Flexboard » (par opposition à la plaque rigide supportant les pistes conductrices dans les autres circuits imprimés). L'avantage de ces circuits est que l'on peut donner des orientations variables à ses extrémités l'une par rapport à l'autre. On peut également lui donner différentes configurations en la courbant selon différentes directions.
Selon un mode avantageux de l'invention, les moyens de positionnement comprennent au moins un élément, préférentiellement un pion, destiné à coopérer avec une ouverture correspondante pratiquée dans le dans le circuit imprimé souple. Typiquement le circuit imprimé souple présente deux trous que l'on positionne sur deux pions, ces pions étant ensuite élargis par bouterollage pour assurer la permanence de la liaison mécanique. Cette liaison simple et peu coûteuse est suffisante pour assurer un positionnement et un maintien du circuit imprimé souple par rapport au support. La liaison électrique n'est alors pratiquement pas sollicitée lors de la manipulation de l'ensemble support-source lumineuse-circuit imprimé souple. Le support de source lumineuse selon l'invention comprend un deuxième logement destiné à recevoir le circuit imprimé souple, ce premier logement et ce deuxième logement étant agencés l'un par rapport à l'autre de manière à positionner le circuit imprimé souple sur le premier circuit imprimé, préférentiellement à proximité d'un des bords du premier circuit imprimé. Cet agencement du support permet une liaison électrique aisée entre le circuit imprimé souple et le premier circuit imprimé. Par exemple, le deuxième logement peut être dans le prolongement du premier logement de sorte à positionner le circuit imprimé souple sur le premier circuit imprimé, à proximité d'un des bords du premier circuit imprimé. Le deuxième logement présente une ouverture voisine de l'ouverture du premier logement.
L'ouverture du deuxième logement donne un accès au circuit imprimé souple plat en vue de pratiquer une opération de soudure entre le circuit imprimé souple superposé au premier circuit imprimé.

Selon un mode avantageux de l'invention, les moyens de positionnement du circuit imprimé souple comprennent des moyens de guidage destinés à agir au niveau des bords longitudinaux du circuit imprimé souple.

Ces moyens de guidage, typiquement deux bords opposés longitudinaux, permettent un alignement satisfaisant du circuit imprimé souple par rapport au support et au premier circuit imprimé.

Selon un mode avantageux de l'invention, le premier logement comprend des bords formés par un enfoncement dans l'épaisseur du support, ces bords entourant au moins partiellement l'ouverture du premier logement. Cela permet une mise en place du premier circuit imprimé par un mouvement simple consistant à déposer le premier circuit imprimé sur son logement. Préférentiellement, lesdits bords entourent complètement l'ouverture du premier logement, permettant ainsi de positionner plus facilement le premier circuit imprimé. Selon une variante de réalisation, le support est un élément essentiellement plat avec une épaisseur, le premier logement comprenant les bords formés par l'enfoncement dans l'épaisseur du support.

Selon un mode avantageux de l'invention, le support comprend un deuxième logement destiné à recevoir le circuit imprimé souple et comprenant des bords formés par un enfoncement dans l'épaisseur du support dans le prolongement de l'enfoncement du premier logement.

Cet agencement permet un alignement du premier circuit imprimé et du circuit imprimé souple au moyen de mesures simples et communes. Il en résulte une conception du support simplifiée et donc moins coûteuse.

Selon un mode avantageux de l'invention, les bords du deuxième logement présentent une ouverture vers l'extérieur pour l'accès du circuit imprimé souple au support, lesdits bords comprenant une partie en coin de part et d'autre de l'ouverture formant ainsi une retenue du circuit imprimé souple vers l'extérieur du support.

La partie en coin permet un calage du circuit imprimé souple selon un axe longitudinal et donc un positionnement axial précis.

Selon un mode avantageux de l'invention, les bords du premier et/ou deuxième logement comprennent des moyens de maintien du premier circuit imprimé audit support. Selon un mode de réalisation, ces moyens de maintien sont des excroissances déformables servant à un positionnement précis et/ou des moyens de clippage tels des crochets résilients servant à retenir le premier circuit imprimé.

Les excroissances, typiquement des pointes ou coins, permettent un montage du premier circuit imprimé sans jeu tout en permettant une certaine tolérance de fabrication au niveau des dimensions du premier circuit imprimé et des bords du support. Elles permettent par exemple de fixer le premier circuit imprimé en le rentrant en force dans le logement. Elles sont alors déformées et exercent alors une force de maintien sur le premier circuit imprimé.

L'invention consiste également en un dispositif à source lumineuse comprenant un support tel que décrit ci-avant, une source lumineuse montée sur un premier circuit imprimé, le premier circuit imprimé étant logé dans le support, et un circuit imprimé souple relié au support, préférentiellement mécaniquement et électriquement.

Selon un mode avantageux de l'invention, le circuit imprimé souple est relié mécaniquement au support par au moins un pion du support coopérant par insertion avec une ouverture correspondante du circuit imprimé souple, l'extrémité du pion étant élargie par bouterollage après insertion dans l'ouverture.

Selon un mode avantageux de l'invention, l'extrémité du circuit imprimé souple du côté du support est superposée au premier circuit imprimé et est relié électriquement au premier circuit imprimé par soudure laser ou une soudure a chaud de type « Hot Bar ».

Selon un mode avantageux de l'invention, l'extrémité du circuit imprimé souple du côté du support est disposée à côté du premier circuit imprimé et est relié électriquement au premier circuit imprimé par soudure filaire.

Selon un mode avantageux de l'invention, le dispositif comprend un connecteur à l'extrémité du circuit imprimé souple opposée au support.

L'invention consiste également en un module d'éclairage ou de signalisation comprenant un support tel que décrit ci-avant ou un dispositif à source lumineuse tel que décrit ci-avant. Selon un mode avantageux de l'invention, le dispositif à source lumineuse est fixé sur un refroidisseur, par exemple un dissipateur thermique, préférentiellement un radiateur à ailettes.
D'autres caractéristiques et avantages de la présente invention seront mieux compris à l'aide de la description et des dessins parmi lesquels :
La figure 1 est une vue en perspective du support selon un mode de réalisation de l'invention.
La figure 2 est une vue en perspective du support de la figure 1 avec un circuit imprimé souple d'alimentation avec son connecteur.
La figure 3 est une vue en perspective d'un dispositif à source lumineuse selon la présente invention comprenant le support avec un circuit imprimé souple similaire à la figure 2 ainsi que la source lumineuse (non visible) fixée sur le premier circuit imprimé.
La figure 4 est une vue en perspective du support avec une section de circuit imprimé souple et le premier circuit imprimé similaire à la figure 3 avec, en plus, une interface thermique sur le dos du premier circuit imprimé.
La figure 5 est une vue en coupe selon l'axe A-B du support équipé du premier circuit imprimé et de la source lumineuse tel qu'illustré à la figure 3.
La figure 6 est une vue en perspective du premier circuit imprimé avec la diode à électroluminescence.
La figure 7 est une vue en perspective du premier circuit imprimé dans son logement.
La figure 8 est une vue en perspective d'un support selon les figures précédentes avec des moyens alternatifs pour la retenue du premier circuit imprimé sur le support.
La figure 10 est une vue en perspective du dispositif complet tel qu'illustré à la figure 4 et disposé sur un dissipateur thermique.
La figure 11 est une vue en perspective montrant deux modules d'éclairage comprenant, chacun, un support et un dispositif de source lumineuse selon l'invention.

La description de l'invention qui est faite ci-après fait intervenir des termes d'orientation tels que, par exemple, « supérieur » et « inférieur » de certains éléments ou certaines parties du support et des dispositifs illustrés aux figures de la demande. Ces termes sont à interpréter de manière relative par rapport aux représentations de figures et non de manière absolue. Le support décrit et le dispositif de source lumineuse comprenant ledit support peuvent en effet être mis en place dans un module d'éclairage dans diverses positions et orientations.

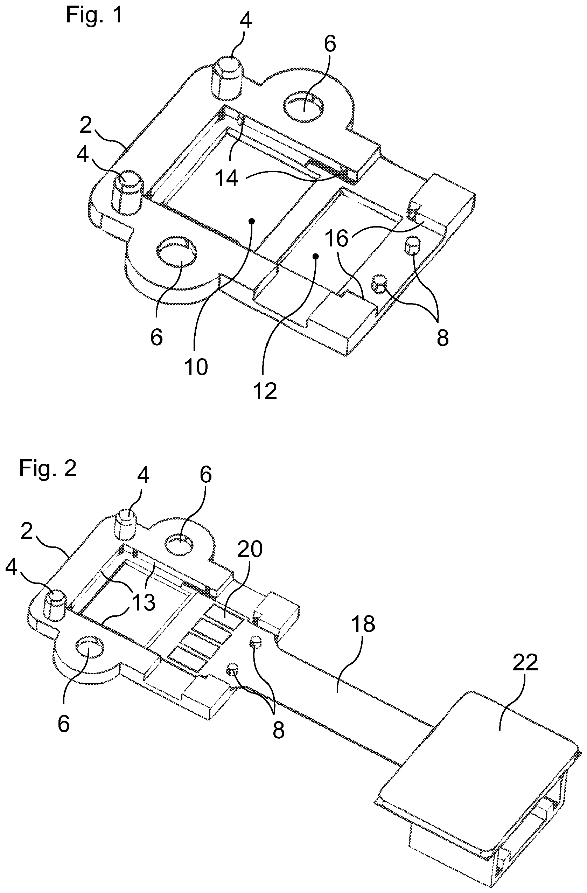

Le support 2 illustré aux figures 1 à 5 et 7 à 8, correspond à un premier mode de réalisation de l'invention. Les figures 1 à 4 et 7 à 8 représentent le support vu du côté de la face destinée à être fixé contre un élément d'un module d'éclairage. Il consiste en un élément essentiellement plat avec une certaine épaisseur relativement constante. Il s'agit d'une pièce en matériau isolant électriquement, préférentiellement en matériau plastique injecté du type PBT ou PBTP qui est l'abréviation de Polybutylène Téréphthalate ou Polytéréphtalate de Butylène et qui désigne une matière plastique de type Polyester. Le matériau doit également résister à des températures imposées par le dégagement de chaleur de la source lumineuse, typiquement de l'ordre de 12°C.

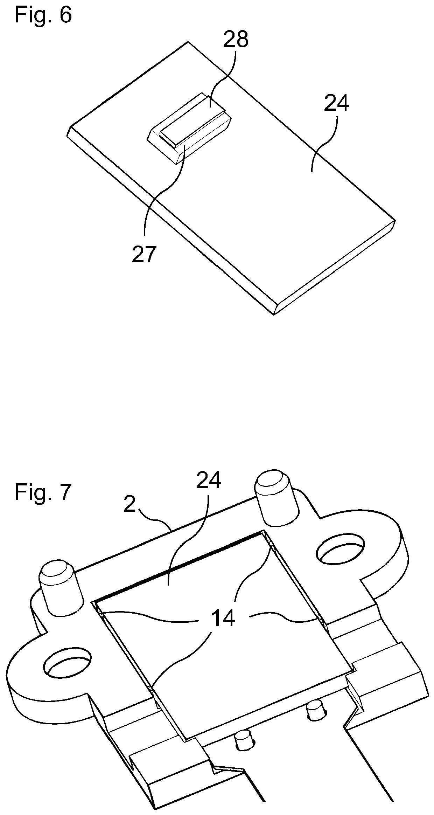

Ce support est destiné à maintenir un premier circuit imprimé sur lequel est fixé une DEL. Un tel circuit imprimé comprenant une DEL est illustré en figure 6. La DEL comprend un élément photoémissif 28 qui, lorsqu'il est mis sous tension, émet de la lumière. Cet élément photoémissif est monté sur un substrat 27 qui porte les électrodes alimentant cet élément photoémissif. Le substrat 27 est fixé sur une face du premier circuit imprimé 24. Les électrodes (non représentées) sont connectées aux pistes de ce circuit imprimé 24. Le substrat est isolant électrique et conducteur thermique, pour permettre un transfert de chaleur vers un élément conducteur thermique, qui dans l'exemple illustré débouche sur l'autre face du premier circuit imprimé. Dans certaines variantes de réalisation (non représentées), le substrat et le premier circuit imprimé peuvent constituer une seule et même pièce. Le support selon la présente invention reste adapté à ces variantes de réalisation.

Le support comporte deux pions 4 de positionnement par rapport à un module d'éclairage ainsi que deux oeillères 6 de fixation. Il comporte également une cavité formée par un évidement rectangulaire. Cet évidement comprend des bords 13 en forme de U destiné à recevoir les bords du premier circuit imprimé de la source lumineuse. Les bords forment un premier logement réservé à la source lumineuse. Une ouverture 10 est pratiquée dans le premier logement afin d'assurer un accès aux deux faces du premier circuit imprimé. Des excroissances 14 en forme de pointes ou arrondies sont prévus le long des bords 13 afin de venir en contact avec les bords extérieurs du premier circuit imprimé et d'assurer un positionnement précis tout en permettant une certaine tolérance au niveau des dimensions extérieures du premier circuit imprimé et du premier logement. Lorsque le premier circuit imprimé 24 est enfoncé dans le premier logement, ces excroissances 14 se déforment selon une direction essentiellement parallèle au plan du premier circuit imprimé 24 en direction des bords 13 du premier logement. Par leur élasticité, elles vont alors exercer une force de maintien en sens opposé à leur déformation et assurer ainsi le maintien du premier circuit imprimé 24 dans le premier logement du support 2.

Un deuxième logement est formé dans le support 2 par la continuité des bords 13, soit sur les figures 1 et 2 vers la partie droite du support 2. Ce deuxième logement se prolonge également par des bords 16. Ce deuxième logement présente également une ouverture 12 destinée à permettre un accès au circuit imprimé souple destiné à être logé et fixé dans le deuxième logement.

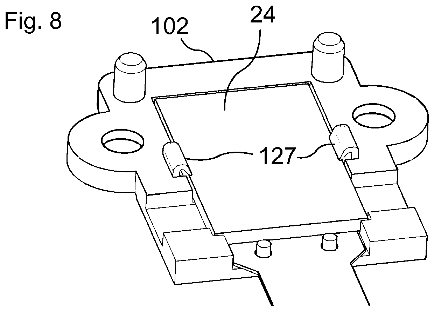

Comme cela est illustré à la figure 2, un circuit imprimé souple 18 ou encore « flexboard » ou « Flexible Printed Circuit » est utilisé pour faire la liaison électrique entre la source lumineuse et le connecteur 22. Le circuit imprimé souple 18 de la figure 2 comprend quatre pistes électriques (non représentées) qui courent le long du circuit imprimé souple et sont reliées électriquement au connecteur 22. Deux pistes servent à l'alimentation en énergie électrique de la source lumineuse et les deux autres pistes servent à être reliées à une thermistance du type CTN (coefficient de température négatif) dont la résistance diminue de manière uniforme avec la température. La thermistance (non représentée) permet un contrôle de la température régnant au niveau du substrat 27 à proximité de la source lumineuse 28. Il est à noter que la présence de moyens de surveillance de la température n'est pas obligatoire. Les pistes se terminent du côté support, chacune, par une surface de contact 20 destinée à entrer en contact avec une surface de contact correspondante du premier circuit imprimé. L'extrémité côté support du circuit imprimé souple présente une forme élargie en vue d'épouser les bords 16 et 13 du support. Cette partie du circuit imprimé souple présente deux orifices traversés, chacun, par un pion 8. Il résulte de cet agencement un positionnement précis du circuit imprimé souple et plus particulièrement des surfaces de contact 20 par rapport au support.

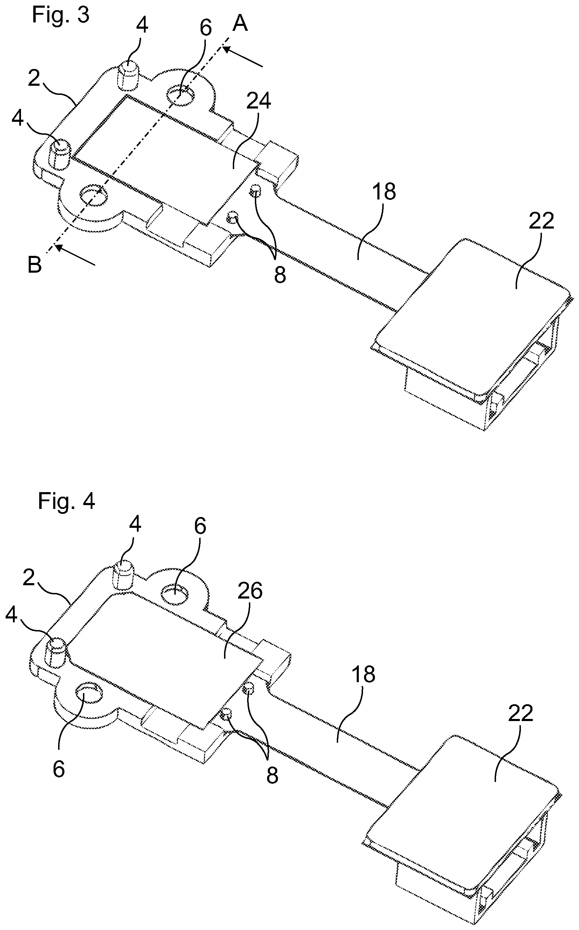

La figure 3 illustre le support de la figure 2 où le premier circuit imprimé 24 avec la source lumineuse (non représentée à cette figure car de l'autre côté de la face du premier circuit imprimé qui est visible sur cette figure) est mis en place dans son logement. Le logement en question est constitué du logement en forme de U et du logement du circuit imprimé souple. Une partie du premier circuit imprimé 24 recouvre le circuit imprimé souple de sorte à mettre ses contacts électriques (non représentés) en face des contacts électriques 20 du circuit imprimé souple.
L'ouverture 12 du deuxième logement procure un accès pour une opération de soudage des contacts 20 du circuit imprimé souple avec les contacts correspondants du premier circuit imprimé 24. L'opération de soudage peut être du type laser ou une soudure a chaud de type « Hot Bar ». La soudure Hot Bar est un procédé permettant de souder deux circuits imprimés (principalement un circuit imprimé souple sur un circuit rigide) à l'aide d'une thermode. Pendant l'opération de soudage, une thermode est appliquée sur les pièces avec une pression prédéterminée, cela permet de maintenir correctement le circuit imprimé souple pendant l'opération et d'obtenir un bon contact lors du soudage simultané de toutes les pattes du circuit imprimé souple sur les plages du premier circuit imprimé. La phase de soudure se caractérise par un profil de température en palier, elle se décompose en trois séquences : temps de montée, plage de maintien et temps de refroidissement. Ce processus permet la création d'une connexion électromécanique permanente entre les pièces.
D'autres méthodes de soudure ou brasage connues de l'homme métier peuvent être envisagées.
Une interface thermique 26 telle qu'illustrée à la figure 4 est disposée sur la face du premier circuit imprimé 24 opposée à la face portant la DEL. Cette interface a pour but d'assurer une bonne conduction thermique entre le premier circuit imprimé et le radiateur ou diffuseur de chaleur (non représenté) sur lequel le support est fixé et l'interface thermique 26 est appliquée.

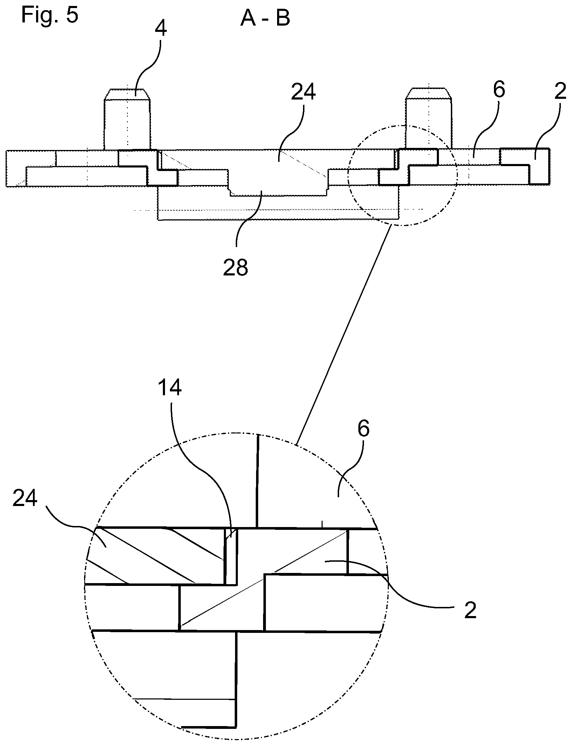

La figure 5 est une vue en coupe selon l'axe A-B du support 2 équipé du premier circuit imprimé 24 et de la source lumineuse 28. On peut y observer la section en escalier des bords du support formant le logement du premier circuit imprimé. La vue agrandie, entourée en pointillée sur la figure 5, de la section en escalier illustre une des excroissances 14 en forme de pointe présente sur le bord du logement. Elle est de section généralement triangulaire ou en demi-cylindre et est orientée selon une direction généralement perpendiculaire au plan du logement et/ou du support. Elle présente une extrémité biseautée du côté extérieur du logement destinée à faciliter le centrage et l'insertion du premier circuit imprimé dans le logement. Avantageusement la surface extérieure (par rapport au logement) du premier circuit imprimé et alignée avec la surface correspondante du support de manière à pouvoir recevoir l'interface thermique 26 (figure 4).
La figure 7 correspond essentiellement à la figure 3, illustrant plus en détail le premier circuit imprimé logé dans le support et maintenu en place par les excroissances en forme de pointes 14 le long des bords du logement.
Des moyens alternatifs ou complémentaires à ceux décrits en relation avec les figures 1-7 et servant à maintenir le premier circuit imprimé dans son logement sont illustrés à la figure 8. Le support 102 comporte deux crochets 127 disposés sur des bords opposés du logement du premier circuit imprimé 24. Ces crochets sont élastiques et conçus de manière à ce que leurs bords d'accrochage fléchissent lors de la mise en place du premier circuit imprimé 24 et à ce que ces bords d'accrochage reprennent leur forme initiale après insertion du premier circuit imprimé 24. Le nombre de crochet peut être variable pour autant qu'ils soient disposés sur des bords opposés du logement.

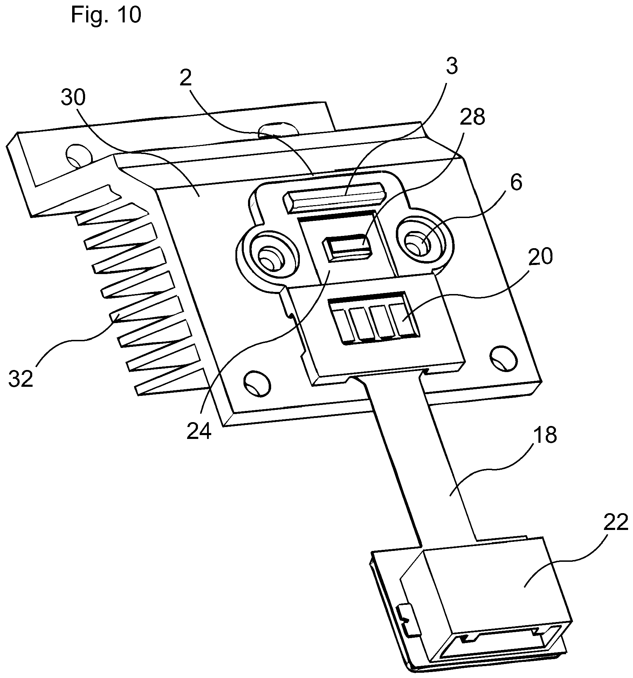

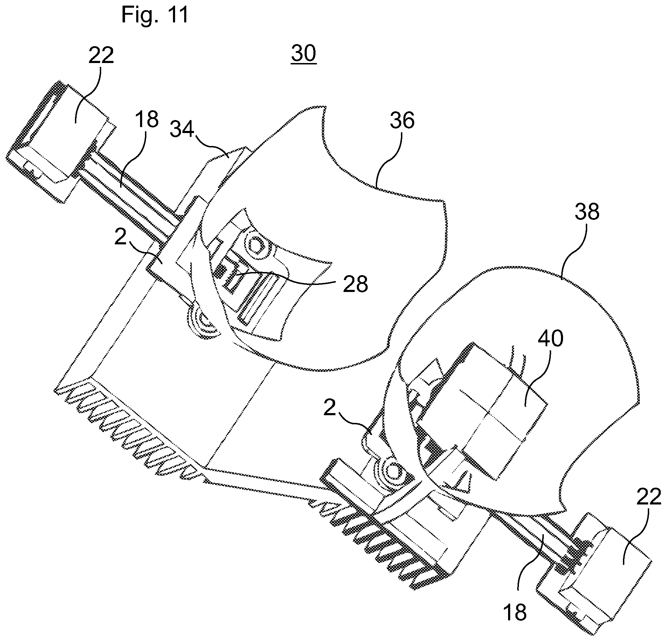

La figure 10 est une illustration du montage du dispositif sur un dissipateur de chaleur 30. Les oeillères de fixation 6 sont prêtes à recevoir des moyens de fixation tels des vis ou rivets en vue de fixer le support au dissipateur de chaleur 30. La face arrière du premier circuit imprimé 24 est en contact via une interface thermique avec une surface correspondante du dissipateur de chaleur, ce dernier comportant des ailettes 32 destinées à évacuer la chaleur produite par l'élément photoémissif 28 de la DEL.
Deux modules d'éclairage comportant un support conforme au premier mode de réalisation sont illustrés à la figure 11. Le dispositif d'éclairage 30 comprend un dissipateur de chaleur 34 commun aux deux modules. Deux assemblages conformes à celui des figures 4 et 5 sont disposés sur le dissipateur 34. Chaque assemblage est comprend un support 2, une source lumineuse 28 du type à électroluminescence sur un premier circuit imprimé, et un circuit imprimé souple comportant un connecteur 22 à une extrémité. L'autre extrémité du circuit imprimé souple est mécaniquement reliée au support 2 et électriquement relié au premier circuit imprimé. Chaque module comprend un réflecteur 36 et 38, ayant chacun une surface concave réfléchissante à profil parabolique. Une lentille 40 est prévue dans la cavité du réflecteur 38 du second module, de manière à ce qu'une partie de la lumière passe au travers.

La souplesse du circuit imprimé souple 18 permet une grande liberté d'orientation du support de source lumineuse tout en permettant un branchement du connecteur 22 à l'électronique d'alimentation assez aisé quel que soit la conception et la géométrie du projecteur comprenant les modules d'éclairage de la figure 11.

Les supports tels que décrits ci-avant peuvent avantageusement s'appliquent à des modules d'éclairage comprenant plusieurs sources lumineuses. En effet, dans ce cas, on peut prévoir un câble plat ou préférentiellement un circuit imprimé souple comprenant à une extrémité un connecteur similaire au connecteur 22 des figures 2 à 4 et 10 et se ramifiant à l'autre extrémité en autant de branches qu'il y a de sources lumineuses, chaque branche étant reliée à un support selon l'invention. Les pistes électriques partant du connecteur se verront donc multipliées au niveau des ramifications ou, alternativement ou en supplément, certaines pourront être spécifiques à certaines sources lumineuses, en fonction du dispositif d'éclairage destiné à recevoir un tel assemblage et selon les fonctions d'éclairage et/ou de signalisation à assurer.

## Revendications

1. Support (2 ; 102) de source lumineuse (28) fixée sur un premier circuit imprimé (24) pour un module d'éclairage et/ou de signalisation, le support comprenant :
un premier logement destiné à recevoir le premier circuit imprimé (24) et présentant une ouverture (10) pour la source lumineuse (28) ;
des moyens de positionnement et de fixation (4, 6) du support (2 ; 102) par rapport au module d'éclairage ;
des moyens de positionnement (8, 16) d'un deuxième circuit imprimé qui est un circuit imprimé souple (18), ces moyens de positionnement étant destinés à positionner le circuit imprimé souple par rapport au premier circuit imprimé en vue de permettre une liaison électrique entre le circuit imprimé souple et le premier circuit imprimé,
**caractérisé en ce qu'**il comprend un deuxième logement destiné à recevoir le circuit imprimé souple (18), ledit premier logement et ledit deuxième logement étant agencés l'un par rapport à l'autre de manière à positionner le circuit imprimé souple sur le premier circuit imprimé, préférentiellement à proximité d'un des bords du premier circuit imprimé (24), de sorte à mettre des contacts électriques du premier circuit imprimé (24) en face des contact électriques (20) du circuit imprimé souple (18), le deuxième logement présentant une ouverture (12) voisine de l'ouverture (10) du premier logement, ladite ouverture (12) du deuxième logement donnant un accès pour une opération de soudage des contacts (20) du circuit imprimé souple (18) avec les contacts correspondants du premier circuit imprimé (24).

2. Support (2; 102) de source lumineuse selon la revendication précédente, **caractérisé en ce que** les moyens de positionnement (8, 16) comprennent au moins un élément, préférentiellement un pion (8), destiné à coopérer avec une ouverture correspondante pratiquée dans le circuit imprimé souple (18).

3. Support (2; 102) de source lumineuse selon l'une des revendications précédentes, **caractérisé en ce que** les moyens de positionnement (8, 16) du circuit imprimé souple (18) comprennent des moyens de guidage (16) destinés à agir au niveau des bords longitudinaux du circuit imprimé souple.

4. Support (2 ; 102) de source lumineuse selon l'une des revendications précédentes, **caractérisé en ce que** le premier logement comprend des bords (13) formés par un enfoncement dans l'épaisseur du support (2), lesdits bords entourant au moins partiellement l'ouverture du premier logement.

5. Support (2 ; 102) de source lumineuse selon la revendication 4, **caractérisé en ce que** les bords (13) du premier et/ou deuxième logement comprennent des moyens de maintien du premier circuit imprimé (24) audit support (2, 102).

6. Support (2 ; 102) de source lumineuse selon la revendication 5, **caractérisé en ce que** lesdits moyens de maintiens sont des excroissances (14) déformables servant à un positionnement précis et/ou des moyens de clippage tels des crochets résilients (127).

7. Support (2; 102) de source lumineuse selon l'une quelconque des revendications 4 à 6, **caractérisé en ce qu'**il comprend un deuxième logement destiné à recevoir le circuit imprimé souple (18) et comprenant des bords (16) formés par un enfoncement dans l'épaisseur du support dans le prolongement de l'enfoncement du premier logement.

8. Support (2; 102) de source lumineuse selon la revendication précédente, **caractérisé en ce que** les bords (16) du deuxième logement présentent une autre ouverture vers l'extérieur, pour l'accès du circuit imprimé souple au support, lesdits bords (16) comprenant une partie en coin de part et d'autre de l'ouverture formant ainsi une retenue du circuit imprimé souple vers l'extérieur du support.

9. Dispositif à source lumineuse comprenant un support (2 ; 102 ;) selon l'une des revendications précédentes, une source lumineuse (28) montée sur un premier circuit imprimé (24), le premier circuit imprimé (24) étant logé dans ledit support (2 ; 102 ;), et un circuit imprimé souple (18) relié au support, préférentiellement mécaniquement et électriquement.

10. Dispositif à source lumineuse selon la revendication précédente, **caractérisé en ce que** le circuit imprimé souple (18) est relié mécaniquement au support (2 ; 102 ;) par au moins un pion (8) du support coopérant par insertion avec une ouverture correspondante du circuit imprimé souple, l'extrémité du pion étant élargie, préférentiellement par bouterollage, après insertion dans l'ouverture.

11. Dispositif à source lumineuse selon l'une quelconque des revendications 9 à 10, **caractérisé en ce que** l'extrémité du circuit imprimé souple (18) du côté du support (2 ; 102) est superposée au premier circuit imprimé (24) et est relié électriquement au premier circuit imprimé par soudure laser ou une soudure a chaud de type « Hot Bar ».

12. Dispositif à source lumineuse selon l'une quelconque des revendications 9 à 11, **caractérisé en ce qu'**il comprend un connecteur (22) à l'extrémité du circuit imprimé souple (18) opposée au support (2; 102).

13. Module d'éclairage ou de signalisation comprenant un support selon l'une des revendications 1 à 8 ou un dispositif à source lumineuse selon l'une des revendications 9 à 11.

## Patentansprüche

1. Halterung (2; 102) für Lichtquelle (28), die auf einer ersten Leiterplatte (24) befestigt ist, für ein Beleuchtungs- und/oder Signalisierungsmodul, wobei die Halterung Folgendes aufweist:
eine erste Aufnahme, die dazu bestimmt ist, die erste Leiterplatte (24) aufzunehmen und eine Öffnung (10) für die Lichtquelle (28) aufweist;
Mittel zum Positionieren und Befestigen (4, 6) der Halterung (2; 102) gegenüber dem Beleuchtungsmodul;
Mittel zum Positionieren (8, 16) einer zweiten Leiterplatte, die eine flexible Leiterplatte (18) ist, wobei diese Mittel zum Positionieren dazu bestimmt sind, die flexible Leiterplatte gegenüber der ersten Leiterplatte zu positionieren, um eine elektrische Verbindung zwischen der flexiblen Leiterplatte und der ersten Leiterplatte zu ermöglichen,
**dadurch gekennzeichnet, dass** sie eine zweite Aufnahme aufweist, die dazu bestimmt ist, die flexible Leiterplatte (18) aufzunehmen, wobei die erste Aufnahme und die zweite Aufnahme zueinander derart angeordnet sind, um die flexible Leiterplatte auf der ersten Leiterplatte, vorzugsweise in der Nähe von einem der Ränder der ersten Leiterplatte (24), derart zu positionieren, um elektrische Kontakte der ersten Leiterplatte (24) gegenüberliegend von den elektrischen Kontakten (20) der flexiblen Leiterplatte (18) anzuordnen, wobei die zweite Aufnahme eine Öffnung (12) benachbart zu der Öffnung (10) der ersten Aufnahme aufweist, wobei die Öffnung (12) der zweiten Aufnahme einen Zugang für einen Verlötvorgang der Kontakte (20) der flexiblen Leiterplatte (18) mit den entsprechenden Kontakten der ersten Leiterplatte (24) ermöglicht.

2. Halterung (2; 102) für Lichtquelle nach dem vorhergehenden Anspruch, **dadurch gekennzeichnet, dass** die Mittel zum Positionieren (8, 16) mindestens ein Element, vorzugsweise einen Stift (8), aufweisen, das dazu bestimmt ist, mit einer entsprechenden Öffnung zusammenzuwirken, die in der flexiblen Leiterplatte (18) ausgebildet ist.

3. Halterung (2; 102) für Lichtquelle nach einem der vorhergehenden Ansprüche, **dadurch gekennzeichnet, dass** die Mittel zum Positionieren (8, 16) der flexiblen Leiterplatte (18) Führungsmittel (16) aufweisen, die dazu bestimmt sind, an den Längsrändern der flexiblen Leiterplatte einzuwirken.

4. Halterung (2; 102) für Lichtquelle nach einem der vorhergehenden Ansprüche, **dadurch gekennzeichnet, dass** die erste Aufnahme Ränder (13) aufweist, die durch eine Einsenkung in der Dicke der Halterung (2) gebildet sind, wobei die Ränder mindestens teilweise die Öffnung der ersten Aufnahme umgeben.

5. Halterung (2; 102) für Lichtquelle nach Anspruch 4, **dadurch gekennzeichnet, dass** die Ränder (13) der ersten und/oder zweiten Aufnahme Mittel zum Halten der ersten Leiterplatte (24) an der Halterung (2, 102) aufweisen.

6. Halterung (2; 102) für Lichtquelle nach Anspruch 5, **dadurch gekennzeichnet, dass** die Mittel zum Halten verformbare Vorsprünge (14), die zu einem präzisen Positionieren dienen, und/oder Klemmmittel wie elastische Haken (127) sind.

7. Halterung (2; 102) für Lichtquelle nach einem der Ansprüche 4 bis 6, **dadurch gekennzeichnet, dass** sie eine zweite Aufnahme aufweist, die dazu bestimmt ist, die flexible Leiterplatte (18) aufzunehmen und die Ränder (16) aufweist, die durch eine Einsenkung in der Dicke der Halterung in der Verlängerung der Einsenkung der ersten Aufnahme gebildet sind.

8. Halterung (2; 102) für Lichtquelle nach dem vorhergehenden Anspruch, **dadurch gekennzeichnet, dass** die Ränder (16) der zweiten Aufnahme eine andere Öffnung zur Außenseite für den Zugang der flexiblen Leiterplatte zur Halterung aufweisen, wobei die Ränder (16) einen Eckabschnitt beiderseits der Öffnung aufweisen und so einen Halt der flexiblen Leiterplatte zur Außenseite der Halterung bilden.

9. Vorrichtung mit Lichtquelle, umfassend eine Halterung (2; 102) nach einem der vorhergehenden Ansprüche, eine Lichtquelle (28), die auf einer ersten Leiterplatte (24) befestigt ist, wobei die erste Leiterplatte (24) in der Halterung (2; 102) untergebracht ist, und eine flexible Leiterplatte (18), die mit der Halterung vorzugsweise mechanisch und elektrisch verbunden ist.

10. Vorrichtung mit Lichtquelle nach dem vorhergehenden Anspruch, **dadurch gekennzeichnet, dass** die flexible Leiterplatte (18) durch mindestens einen Stift (8) der Halterung, der durch Einfügen mit einer entsprechenden Öffnung der flexiblen Leiterplatte zusammenwirkt, wobei das Ende des Stiftes vorzugsweise durch Aufweiten nach dem Einfügen in die Öffnung verbreitert wird, mechanisch mit der Halterung (2; 102) verbunden ist.

11. Vorrichtung mit Lichtquelle nach einem der Ansprüche 9 bis 10, **dadurch gekennzeichnet, dass** das Ende der flexiblen Leiterplatte (18) auf der Seite der Halterung (2; 102) der ersten Leiterplatte (24) überlagert ist und mit der ersten Leiterplatte durch Laserlöten oder ein Löten des Typs des "Hot-Bar-Reflow-Lötens" elektrisch verbunden ist.

12. Vorrichtung mit Lichtquelle nach einem der Ansprüche 9 bis 11, **dadurch gekennzeichnet, dass** sie einen Steckverbinder (22) an dem Ende der flexiblen Leiterplatte (18) aufweist, das der Halterung (2; 102) gegenüberliegt.

13. Beleuchtungs- oder Signalisierungsmodul, umfassend eine Halterung nach einem der Ansprüche 1 bis 8 oder eine Vorrichtung mit Lichtquelle nach einem der Ansprüche 9 bis 11.

## Claims

1. Support (2; 102) for a light source (28) that is attached to a first printed circuit board (24) for a lighting and/or signalling module, the support comprising:
a first housing that is intended to receive the first printed circuit board (24) and that has an opening (10) for the light source (28);
means (4, 6) for positioning and attaching the support (2; 102) with respect to the lighting module;
means (8, 16) for positioning a second printed circuit board, which is a flexible printed circuit board (18), these positioning means being intended to position the flexible printed circuit board with respect to the first printed circuit board with a view to enabling an electrical link between the flexible printed circuit board and the first printed circuit board,
**characterized in that** it comprises a second housing that is intended to receive the flexible printed circuit board (18), said first housing and said second housing being arranged with respect to one another so as to position the flexible printed circuit board on the first printed circuit board, preferably in proximity to one of the edges of the first printed circuit board (24), so that electrical contacts of the first printed circuit board (24) are placed facing electrical contacts (20) of the flexible printed circuit board (18), the second housing having an opening (12) neighbouring the opening (10) of the first housing, said opening (12) of the second housing providing access for an operation of soldering the contacts (20) of the flexible printed circuit board (18) to the corresponding contacts of the first printed circuit board (24).

2. Support (2; 102) for a light source according to the preceding claim, **characterized in that** the positioning means (8, 16) comprise at least one element, preferably a pin (8), that is intended to cooperate with a corresponding opening made in the flexible printed circuit board (18).

3. Support (2; 102) for a light source according to one of the preceding claims, **characterized in that** the means (8, 16) for positioning the flexible printed circuit board (18) comprise guiding means (16) that are intended to act on the longitudinal edges of the flexible printed circuit board.

4. Support (2; 102) for a light source according to one of the preceding claims, **characterized in that** the first housing comprises edges (13) that are formed by a recess in the thickness of the support (2), said edges at least partially surrounding the opening of the first housing.

5. Support (2; 102) for a light source according to Claim 4, **characterized in that** the edges (13) of the first and/or second housing comprise means for holding the first printed circuit board (24) on said support (2, 102).

6. Support (2; 102) for a light source according to Claim 5, **characterized in that** said holding means are deformable excrescences (14) used for precise positioning and/or clipping means such as resilient hooks (127).

7. Support (2; 102) for a light source according to any one of Claims 4 to 6, **characterized in that** it comprises a second housing that is intended to receive the flexible printed circuit board (18) and that comprises edges (16) that are formed by a recess in the thickness of the support in the extension of the recess of the first housing.

8. Support (2; 102) for a light source according to the preceding claim, **characterized in that** the edges (16) of the second housing have another opening towards the exterior, for accessing the flexible printed circuit board on the support, said edges (16) comprising a corner portion on either side of the opening thus forming a retainer for the flexible printed circuit board in the direction of the exterior of the support.

9. Light source device comprising a support (2; 102) according to one of the preceding claims, a light source (28) mounted on a first printed circuit board (24), the first printed circuit board (24) being housed in said support (2; 102), and a flexible printed circuit board (18) that is linked to the support, preferably mechanically and electrically.

10. Light source device according to the preceding claim, **characterized in that** the flexible printed circuit board (18) is mechanically linked to the support (2; 102) by at least one pin (8) of the support cooperating by insertion with a corresponding opening of the flexible printed circuit board, the end of the pin being widened, preferably by snap-riveting, after insertion into the opening.

11. Light source device according to either of Claims 9 and 10, **characterized in that** the end of the flexible printed circuit board (18) on the side of the support (2; 102) is superposed over the first printed circuit board (24) and is electrically linked to the first printed circuit board by laser welding or hot bar welding.

12. Light source device according to any one of Claims 9 to 11, **characterized in that** it comprises a connector (22) at the end of the flexible printed circuit board (18) opposite the support (2; 102).

13. Lighting or signalling module comprising a support according to one of Claims 1 to 8 or a light source device according to one of Claims 9 to 11.
